# EUROPEAN PATENT APPLICATION

(11) **EP 4 766 065 A1**
(43) Date of publication of application: **24.06.2026**
(21) Application number: 25220415.1
(22) Date of filing: 03.12.2025
(51) Int. Cl.: H10B 12/00, H10D 30/67

(54) **SEMICONDUCTOR DEVICE**

(30) Priority: 19.12.2024 KR 20240190924
(71) Applicant: Samsung Electronics Co., Ltd., Suwon-si, Gyeonggi-do 16677 (KR)
(72) Inventor: CHOI, Jin Myung, 16677 Suwon-si (KR); AHN, Dongho, 16677 Suwon-si (KR); YOON, Minseo, 16677 Suwon-si (KR); LEE, Jinwoo, 16677 Suwon-si (KR); HORII, Hideki, 16677 Suwon-si (KR)
(74) Representative: Marks & Clerk LLP

(57) **Abstract**

Disclosed is a semiconductor device comprising a substrate, a bit line that extends in a first direction on the substrate, a mold structure on the bit line and extending in a second direction that intersects the first direction, a vertical semiconductor pattern on a top surface of the bit line and a lateral surface of the mold structure, a gate electrode spaced apart from the mold structure and facing the vertical semiconductor pattern and extending in the second direction that intersects the bit line, and a node contact on the vertical semiconductor pattern. The vertical semiconductor pattern comprises a first part, a second part, and a third part that are sequentially on the bit line. A distance that the second part protrudes from the lateral surface of the mold structure is more than a distance that the first part and the third part protrude from the lateral surface.

## Description

### BACKGROUND

Example embodiments relate to a semiconductor device including vertical channel transistors and a method of fabricating the same.

A semiconductor device can include an integrated circuit including metal oxide semiconductor field effect transistors (MOSFETs). As size and design rule of semiconductor devices are gradually decreased, sizes of MOSFETs are also increasingly scaled down. The scale down of MOSFETs may affect operating characteristics of semiconductor devices. Semiconductor devices having improved performance while addressing the challenges due to increased integration of the semiconductor device are currently being researched.

### SUMMARY

Example embodiments of the inventive concepts provide a semiconductor device including vertical channel transistors and a method of fabricating the same.

According to some example embodiments of the inventive concepts, a semiconductor device may include a substrate, a bit line extending in a first direction on the substrate, a mold structure on the bit line and extending in a second direction that intersects the first direction, a vertical semiconductor pattern on a top surface of the bit line and a lateral surface of the mold structure, a gate electrode spaced apart from the mold structure and facing the vertical semiconductor pattern, the gate electrode extending in the second direction that intersects the bit line, and a node contact on the vertical semiconductor pattern. The vertical semiconductor pattern may include a first part, a second part, and a third part that are sequentially disposed on the bit line. A distance that the second part protrudes from the lateral surface of the mold structure is more than a distance that the first part and the third part protrude from the lateral surface.

According to some example embodiments of the inventive concepts, a semiconductor device may include a substrate, a bit line extending in a first direction on the substrate, a mold structure on the bit line and extending in a second direction that intersects the first direction, a vertical semiconductor pattern on a top surface of the bit line and a lateral surface of the mold structure, a gate electrode spaced apart from the mold structure and facing the vertical semiconductor pattern, the gate electrode extending in the second direction that intersects the bit line, and a node contact on the vertical semiconductor pattern. The mold structure may include a first mold pattern, a second mold pattern, and a third mold pattern that are sequentially stacked on the bit line. The second mold pattern may include a material different from a material of the first mold pattern and a material of the third mold pattern. A thickness of the second mold pattern may be greater than a thickness of the first mold pattern.

According to some example embodiments of the inventive concepts, a semiconductor device may include a substrate, a bit line extending in a first direction on the substrate, a mold structure on the bit line and extending in a second direction that intersects the first direction, a vertical semiconductor pattern on a top surface of the bit line and a lateral surface of the mold structure, a gate electrode spaced apart from the mold structure and facing the vertical semiconductor pattern, the gate electrode extending in the second direction that intersects the bit line, and a node contact on the vertical semiconductor pattern. The mold structure may include a first mold pattern, a second mold pattern, and a third mold pattern that are sequentially stacked on the bit line. The vertical semiconductor pattern may include a first part, a second part, and a third part that are sequentially disposed on the bit line. The first part may be on a lateral surface of the first mold pattern. The second part may be on a lateral surface of the second mold pattern. The third part may be on a lateral surface of the third mold pattern. The first part may contact the bit line. The third part may contact the node contact. The second mold pattern may include metal.

According to some example embodiments, a method of fabricating a semiconductor device includes forming a bit line extending in a first direction on a substrate, forming a mold structure on the bit line and extending in a second direction that intersects the first direction, forming a vertical semiconductor pattern on a top surface of the bit line and a lateral surface of the mold structure, the vertical semiconductor pattern including a first part, a second part, and a third part that are sequentially formed on the bit line, and the second part protruding a first distance from the lateral surface of the mold structure and the first part and the third part protruding a second distance from the lateral surface, the first distance being more than the second distance, forming a gate electrode spaced apart from the mold structure and facing the vertical semiconductor pattern, the gate electrode extending in the second direction that intersects the bit line, and forming a node contact on the vertical semiconductor pattern. According to some example embodiments, the second part includes a first oxide semiconductor, and the first part and the third part includes a second oxide semiconductor. According to some example embodiments, the first oxide semiconductor and the second oxide semiconductor include a same element, and an oxygen concentration of the first oxide semiconductor is greater than an oxygen concentration of the second oxide semiconductor. According to some example embodiments, elements included in the second oxide semiconductor differ by at least one from elements included in the first oxide semiconductor. According to some example embodiments, the first oxide semiconductor and the second oxide semiconductor include same elements and have different compositions.

At least some of the above and other features of the invention are set out in the claims.

### BRIEF DESCRIPTION OF THE DRAWINGS

FIG. 1 illustrates a block diagram showing a semiconductor device according to some example embodiments of the inventive concepts.
FIGS. 2 and 3 illustrate perspective views showing a semiconductor device according to some example embodiments of the inventive concepts.
FIG. 4 illustrates a plan view showing a semiconductor device according to some example embodiments of the inventive concepts.
FIG. 5 illustrates a cross-sectional view taken along line A-A' of FIG. 4.
FIG. 6 illustrates a cross-sectional view taken along line B-B' of FIG. 4.
FIG. 7 illustrates an enlarged view showing section EV1 of FIG. 5.
FIG. 8 illustrates a cross-sectional view conceptually showing FIG. 7.
FIG. 9 illustrates a graph showing oxygen concentrations of parts R1, R2, and R3 of FIG. 8.
FIG. 10 illustrates an enlarged view showing section EV1 of FIG. 5.
FIG. 11 illustrates an enlarged view showing section EV1 of FIG. 5.
FIGS. 12, 14, 16, 19, and 21 illustrate plan views showing a method of fabricating a semiconductor device according to some example embodiments of the inventive concepts.
FIGS. 13, 15, 17, 18, 20, 22, 23, and 24 illustrate cross-sectional views showing a method of fabricating a semiconductor device according to some example embodiments of the inventive concepts.

### DETAILED DESCRIPTION OF EXAMPLE EMBODIMENTS

The following will now describe in detail some example embodiments of the inventive concepts with reference to the accompanying drawings.

In the drawings, the thickness of layers, films, panels, regions, etc., are exaggerated for clarity.

In the drawings, parts having no relationship with the description are omitted for clarity, and the same or similar constituent elements are indicated by the same reference numeral throughout the specification.

It will be understood that when an element such as a layer, film, region, or substrate is referred to as being "on" another element, it may be directly on the other element or intervening elements may also be present. In contrast, when an element is referred to as being "directly on" another element, there are no intervening elements present. It will further be understood that when an element is referred to as being "on" another element, it may be above or beneath or adjacent (e.g., horizontally adjacent) to the other element.

As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C," "at least one of A, B, or C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

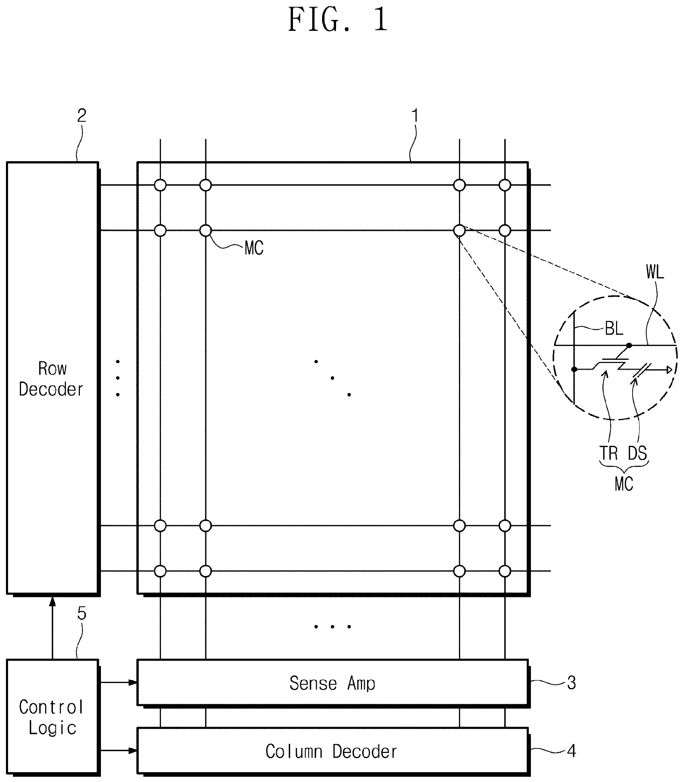

FIG. 1 illustrates a block diagram showing a semiconductor device according to some example embodiments of the inventive concepts.

Referring to FIG. 1, a semiconductor device may include a memory cell array 1, a row decoder 2, a sense amplifier 3, a column decoder 4, and a control logic 5.

The memory cell array 1 may include a plurality of memory cells MC that are arranged two-dimensionally or three-dimensionally. Each of the memory cells MC may be connected between a word line WL and a bit line BL that cross or intersect each other. Each of the memory cells MC may include a selection element TR and a data storage element DS. The selection element TR and the data storage element DS may be electrically connected to each other. The selection element TR may be connected to the word line WL and the bit line BL, and may be provided at intersections between the word line WL and the bit line BL.

The selection element TR may include a field effect transistor. The data storage element DS may include a capacitor, a magnetic tunnel junction pattern, or a variable resistor. When the selection element TR includes a field effect transistor, a gate terminal of the transistor may be connected to the word line WL, and source/drain terminals of the transistor may be connected to the bit line BL and the data storage element DS.

The row decoder 2 may decode an address that is externally input, and may select one of the word lines WL of the memory cell array 1. The address that is decoded in the row decoder 2 may be provided to a row driver, and in response to a control operation of control circuits, the row driver may provide a certain, given, or desired voltage to a selected word line WL and each of non-selected word lines WL.

In response to an address that is decoded from the column decoder 4, the sense amplifier 3 may detect and amplify a voltage difference between a selected bit line BL and a reference bit line, and may then output the amplified voltage difference.

The column decoder 4 may provide a data delivery pathway between the sense amplifier 3 and an external device (e.g., a memory controller). The column decoder 4 may decode externally input address to select one of the bit lines BL in the memory cell array 1. The control logic 5 may generate control signals that control operations to write data to the memory cell array 1 and/or to read data from the memory cell array 1.

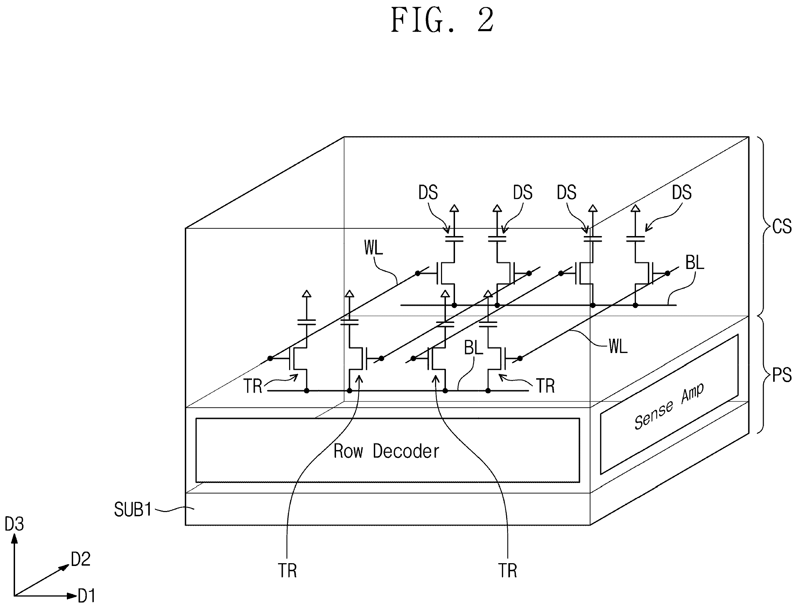

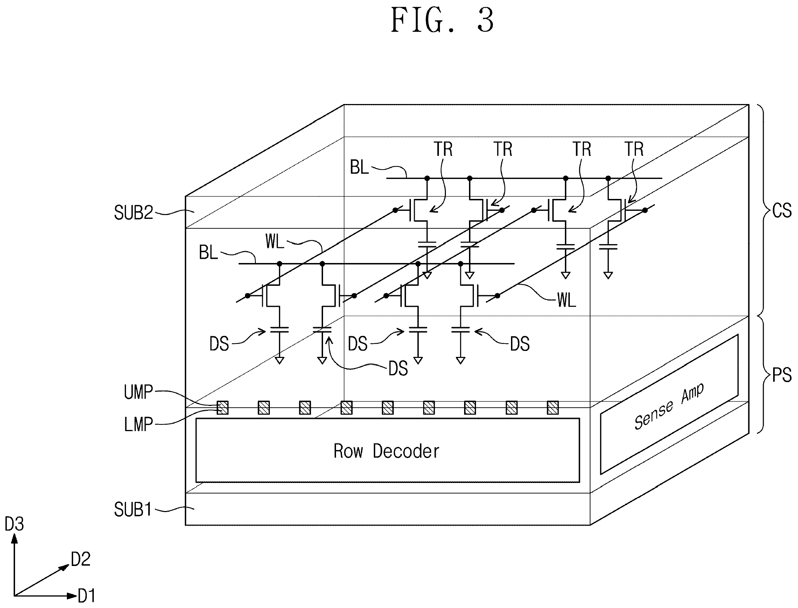

FIGS. 2 and 3 illustrate perspective views showing a semiconductor device according to some example embodiments of the inventive concepts.

Referring to FIGS. 2 and 3, a semiconductor device may include a peripheral circuit structure PS on a first substrate SUB1 and a cell array structure CS on the peripheral circuit structure PS. According to some example embodiments, a first direction D1 and a second direction D2 may be parallel to a top surface of the first substrate SUB1 and intersect each other, and a third direction D3 may be perpendicular to the top surface of the first substrate SUB1. The peripheral circuit structure PS and the cell array structure CS may be stacked in the third direction D3 on the first substrate SUB1. The third direction D3 may define a height direction for the semiconductor device. Components or elements that are located further along the third direction D3 than other components or elements may be considered "above" the other components or elements. The third direction D3 may be a vertical direction. The first direction D1 and the second direction D2 may be horizontal directions. A horizontal direction may be a direction perpendicular to the third direction D3. A "top" surface of an element may be a surface that is located furthest along the third direction D3 (e.g., that faces the third direction D3). A lateral surface of an element may be a surface is located furthest along a horizontal direction (e.g., that defines a lateral extent (e.g., in a horizontal direction) of the element). A lateral surface may be a surface that faces in a horizontal direction. It will be appreciated that the directions and relative positions defined herein are defined relative to the structure of the semiconductor device (e.g., relative to the top surface of the first substrate SUB1) and do not necessarily limit the semiconductor device to a particular orientation in use.

The peripheral circuit structure PS may include core/peripheral circuits formed on the first substrate SUB1. The core/peripheral circuits may include the row and column decoders 2 and 4, the sense amplifier 3, and the control logics 5 that are discussed with reference to FIG. 1.

The cell array structure CS may include the memory cell array (see 1 of FIG. 1) including the memory cells (see MC of FIG. 1) that are arranged two-dimensionally or three-dimensionally. For example, a vertical channel transistor (VCT) may be included as the selection element TR of each memory cell (see MC of FIG. 1). The vertical channel transistor may include a channel pattern elongated in the third direction D3.

Referring to FIG. 2, according to some example embodiments, the peripheral circuit structure PS may be disposed between the first substrate SUB1 and the cell array structure CS, and may be electrically connected through conductive contacts to the cell array structure CS.

Referring to FIG. 3, according to some example embodiments, the semiconductor device may have a chip-to-chip bonding structure. For example, the peripheral circuit structure PS may be provided on the first substrate SUB1, and first metal pads LMP may be disposed on an upper portion of the peripheral circuit structure PS. The first metal pads LMP may be electrically connected to the core/peripheral circuits. The cell array structure CS may be provided on the second substrate SUB2. Second metal pads UMP may be provided on a lower portion of the cell array structure CS. The second metal pads UMP may be electrically connected to the memory cell array (see 1 of FIG. 1). The first metal pads LMP of the peripheral circuit structure PS may be directly bonded to the second metal pads UMP of the cell array structure CS. The peripheral circuit structure PS and the cell array structure CS may be electrically connected to each other through the first and second metal pads LMP and UMP.

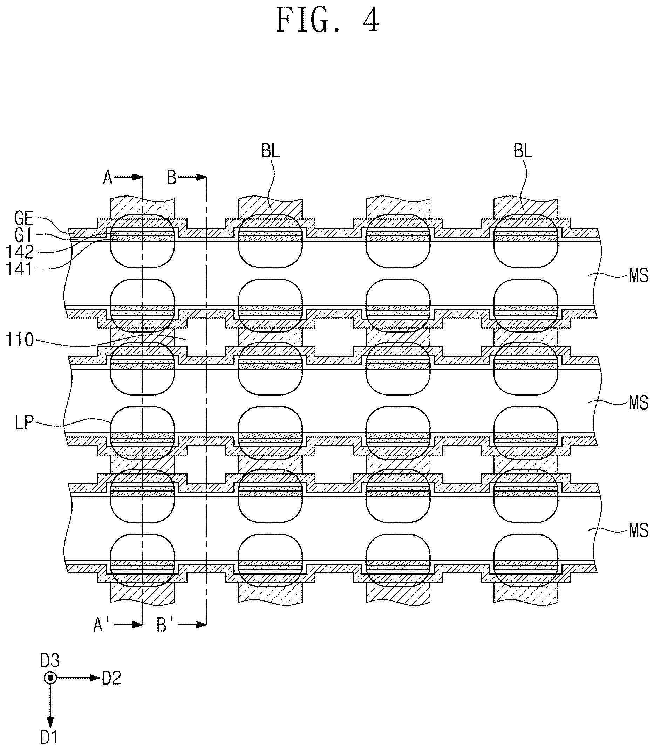

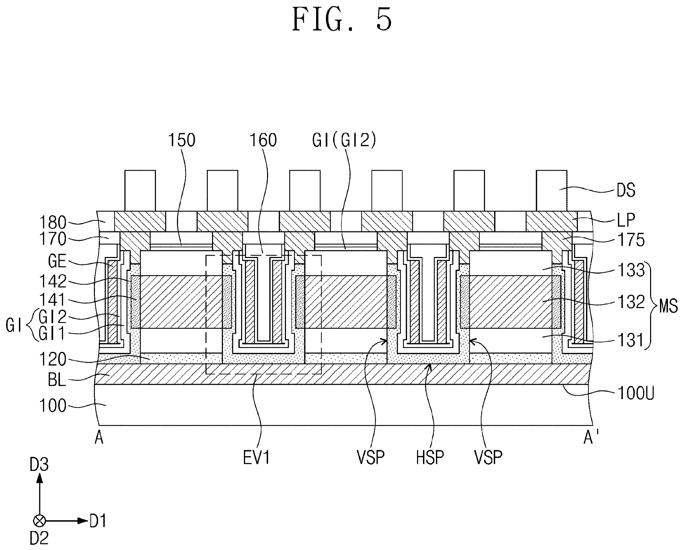

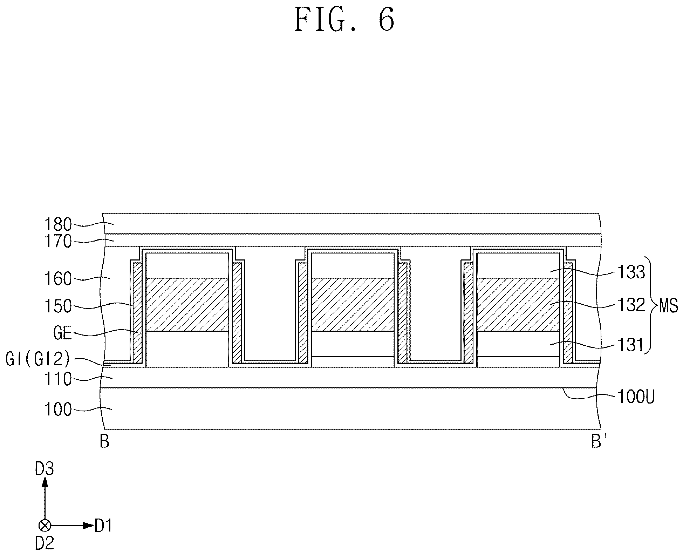

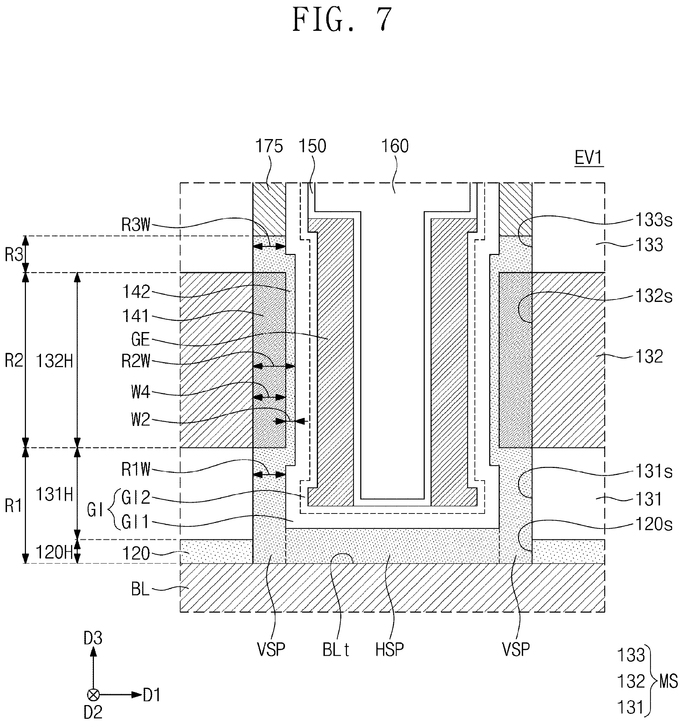

FIG. 4 illustrates a plan view showing a semiconductor device according to some example embodiments of the inventive concepts. FIG. 5 illustrates a cross-sectional view taken along line A-A' of FIG. 4, and FIG. 6 illustrates a cross-sectional view taken along line B-B' of FIG. 4. FIG. 7 illustrates an enlarged view showing section EV1 of FIG. 5. For the sake of clarity of illustration, certain components of FIGS. 5 and 6 are omitted from FIG. 4.

Referring to FIGS. 4, 5, 6, and 7, a substrate 100 may be provided thereon with the cell array structure CS discussed with reference to FIGS. 2 and 3. According to some example embodiments, the substrate 100 may include the first substrate SUB1 and the peripheral circuit structure PS of FIG. 2, and may further include a dielectric layer that covers the peripheral circuit structure PS. The cell array structure CS may be disposed on the dielectric layer. According to some example embodiments, the substrate 100 may further include the second substrate SUB2 of FIG. 3, and may further include a dielectric layer on the second substrate SUB2. The cell array structure CS may be disposed on the dielectric layer. The following description is directed to components of the cell array structure CS.

Bit lines BL may be disposed on the substrate 100. The bit lines BL may extend in the first direction D1 and may be spaced apart from each other in the second direction D2. The first direction D1 and the second direction D2 may be parallel to a top surface 100U of the substrate 100 and may intersect (e.g., orthogonally) each other. First lower dielectric patterns 110 may be interposed between the bit lines BL, and may extend in the first direction D1 between the bit lines BL. The bit lines BL may include a conductive material. For example, the bit lines BL may include at least one doped semiconductor material (e.g., doped silicon or doped germanium), at least one metal (e.g., Ti, Mo, W, Cu, Al, Ta, Ru, Ir, or Co), at least one metal silicide (e.g., silicide of Ti, Mo, W, Cu, Al, Ta, Ru, Ir, or Co), and/or at least one conductive metal nitride (e.g., nitride of Ti, Mo, W, Cu, Al, Ta, Ru, Ir, or Co). According to some example embodiments, the bit lines BL may include a carbon-based two-dimensional material (e.g., graphene), a carbon-based three-dimensional material (e.g., carbon nanotube), or a combination thereof. The first lower dielectric patterns 110 may include a dielectric material, such as silicon oxide, silicon nitride, and/or silicon oxynitride.

Mold structures MS may be formed on and intersect the bit lines BL and the first lower dielectric patterns 110. The mold structures MS may extend in the second direction D2 and may be spaced apart from each other in the first direction D1.

The mold structure MS may include a first mold pattern 131, a second mold pattern 132, and a third mold pattern 133 that are stacked in the third direction D3 perpendicular to the top surface 100U of the substrate 100. The second mold pattern 132 may be disposed between the first mold pattern 131 and the third mold pattern 133. The first mold pattern 131 may extend in the second direction D2 and intersect the bit lines BL and the first lower dielectric patterns 110. The second mold pattern 132 and third mold patterns 133 may be disposed on a top surface of the first mold pattern 131, and may extend in the second direction D2 along the top surface of the first mold pattern 131.

The first mold pattern 131 and the third mold pattern 133 may include a dielectric material, and the second mold pattern 132 may include a metallic material. The first mold pattern 131 and the third mold pattern 133 may include, for example, at least one of silicon nitride (SiN), silicon oxide (SiO₂), silicon carbonitride (SiCN), and silicon oxynitride (SiON). According to some example embodiments, the first mold pattern 131 and the third mold pattern 133 may include the same dielectric material (e.g., silicon nitride).

The second mold pattern 132 may include metal. The second mold pattern 132 may include, for example, at least one of titanium (Ti), titanium nitride (TiN), aluminum (Al), tungsten (W), tungsten nitride (WN), and tungsten silicon nitride (WSiN).

The first mold pattern 131 may have a first height 131H, and the second mold pattern 132 may have a second height 132H. The second height 132H may be greater than the first height 131H. For example, the first height 131H may range from 5 nm (or about 5 nm) to 15 nm (or about 15 nm), and the second height 132H may range from 40 nm (or about 40 nm) to 60 nm (or about 60 nm). The third mold pattern 133 may have a third height, and the third height may be less than the second height 132H. A lateral side of the second mold pattern 132 may be an area where a first oxide semiconductor pattern 141 will be formed, and the second height 132H may determine a channel length of a vertical channel transistor.

A second lower dielectric pattern 120 may be interposed between the mold structure MS and the bit line BL. The second lower dielectric pattern 120 may include a material having an etch selectivity with respect to the first mold pattern 131 and the third mold pattern 133. For example, when the first mold pattern 131 and the third mold pattern 133 include silicon nitride, the second lower dielectric pattern 120 may include silicon oxide. The second lower dielectric pattern 120 may have a fourth height 120H, and the fourth height 120H may be less than the first height 131H. A bottom surface of the second lower dielectric pattern 120 may be in contact with a top surface BLt of the bit line BL.

Vertical semiconductor patterns VSP may be correspondingly disposed on the bit lines BL. A pair of vertical semiconductor patterns VSP may be disposed between neighboring mold structures MS. The vertical semiconductor patterns VSP may be spaced apart from each other in the first direction D1 across (or facing) a corresponding one of the mold structures MS. The vertical semiconductor pattern VSP may be disposed on a lateral surface of a corresponding one of the mold structures MS.

A horizontal semiconductor pattern HSP may be disposed on each of the bit lines BL and between the mold structures MS. The horizontal semiconductor pattern HSP may connect a lower portion of the vertical semiconductor pattern VSP disposed on the lateral surface of one of a pair of neighboring or adjacent (or immediately adjacent) mold structures MS to a lower portion of the vertical semiconductor pattern VSP disposed on the lateral surface of the other of a pair of neighboring mold structures MS. A bottom surface of the horizontal semiconductor pattern HSP may be in contact with the top surface BLt of each of the bit lines BL. The horizontal semiconductor pattern HSP and the lower portions of the vertical semiconductor patterns may be in contact without interfaces. The vertical semiconductor patterns VSP and the horizontal semiconductor pattern HSP may be connected to each other to constitute a single unitary piece, and may be called a semiconductor pattern. The semiconductor pattern VSP and HSP may have a U shape when viewed in cross-section.

The vertical semiconductor pattern VSP may include a first oxide semiconductor pattern 141 and a second oxide semiconductor pattern 142. The horizontal semiconductor pattern HSP may include a second oxide semiconductor pattern 142. The second oxide semiconductor pattern 142 of the vertical semiconductor pattern VSP and the second oxide semiconductor pattern 142 of the horizontal oxide semiconductor pattern HSP may be connected to each other to constitute a single unitary piece. The first oxide semiconductor pattern 141 may be disposed on a lateral surface 132s of the second mold pattern 132. The first oxide semiconductor pattern 141 may not substantially extend onto any of a lateral surface 131s of the first mold pattern 131 and a lateral surface 133s of the third mold pattern 133. The first oxide semiconductor pattern 141 may be in contact with the lateral surface 132s of the second mold pattern 132. The second oxide semiconductor pattern 142 may be disposed on and in contact with the lateral surface 133s of the third mold pattern 133, a top surface and a lateral surface of the first oxide semiconductor pattern 141, the lateral surface 131s of the first mold pattern 131, and the top surface BLt of the bit line BL.

The first oxide semiconductor pattern 141 and the second oxide semiconductor pattern 142 may include an amorphous, crystal, or polycrystalline oxide semiconductor. For example, the oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or any combination thereof. The first oxide semiconductor pattern 141 and the second oxide semiconductor pattern 142 may have bandgap energy greater than that of silicon.

According to some example embodiments, the first oxide semiconductor pattern 141 and the second oxide semiconductor pattern 142 may include oxide semiconductors having the same composition of elements other than oxygen. For example, each of the first oxide semiconductor pattern 141 and the second oxide semiconductor pattern 142 may include InGaZnO. In some example embodiments, an oxygen concentration of the first oxide semiconductor pattern 141 may be greater than that of the second oxide semiconductor pattern 142. Compared to the first oxide semiconductor pattern 141, the second oxide semiconductor pattern 142 may have a higher concentration of carriers (e.g., oxygen vacancies).

According to some example embodiments, the first oxide semiconductor pattern 141 and the second oxide semiconductor pattern 142 may include oxide semiconductors whose elements are the same as each other and whose compositions are different from each other. For example, the first oxide semiconductor pattern 141 may include InₐGa₁₋ₐO (a=0.2~0.4), and the second oxide semiconductor pattern 142 my include In_{b}Ga_{1-b}O (b=0.5~0.7). Compared to the first oxide semiconductor pattern 141, the second oxide semiconductor pattern 142 may have an element composition that is adjusted to obtain a relatively lower interfacial resistance with metal (e.g., with) and/or a high electrical conductivity.

According to some example embodiments, the first oxide semiconductor pattern 141 and the second oxide semiconductor pattern 142 may include different oxide semiconductors from each other. The expression "include different oxide semiconductors" may indicate that at least one element is different. For example, the first oxide semiconductor pattern 141 may include at least one of InAlZnO, InSiZnO, and InZnGaO, and the second oxide semiconductor pattern 142 may include at least one of InGaSnO, InSnO, and InAlZnO. Compared to the first oxide semiconductor pattern 141, the second oxide semiconductor pattern 142 may have a relatively lower interfacial resistance with metal (e.g., with the bit line BL and/or with the node contact 175) and/or a higher electrical conductivity.

The vertical semiconductor pattern VSP may include a first part R1, a second part R2, and a third part R3 that are sequentially disposed in the third direction D3 on the bit line BL. The first part R1 may be disposed on a lateral surface 120s of the second lower dielectric pattern 120 and the lateral surface 131s of the first mold pattern 131, and a bottom surface of the first part R1 may be in contact with the top surface BLt of the bit line BL. The second part R2 may be formed on the lateral surface 132s of the second mold pattern 132, lie between the first part R1 and the third part R3, and extend in the third direction D3. The third part R3 may be disposed on the lateral surface 133s of the third mold pattern 133 and an upper end of the second part R2. A top surface of the third part R3 may be in contact with a node contact 175.

The first part R1 and the third part R3 may be constituted by the second oxide semiconductor pattern 142 (e.g., upper and lower portions of the second oxide semiconductor pattern 142, respectively). The second part R2 may be constituted by the first oxide semiconductor pattern 141 and the second oxide semiconductor pattern 142 (e.g., a middle portion of the second oxide semiconductor pattern 142). In the second part R2, the second oxide semiconductor pattern 142 may be disposed on the first oxide semiconductor pattern 141 (e.g., on a lateral surface of the first oxide semiconductor pattern 141). For example, the second oxide semiconductor pattern 142 of the first part R1 and the third part R3 may extend onto the lateral surface of the first oxide semiconductor pattern 141 in the second part R2.

The vertical semiconductor pattern VSP may have a maximum thickness in the first direction D1 in the second part R2. The vertical semiconductor pattern VSP may have a shape that is crooked, stepped, or protrudes in the first direction D1 in the first part R2. The second part R2 may protrude in the first direction D1 from the first part R1 and the third part R3. For example, a thickness R2W in the first direction D1 of the second part R2 may be greater than a thickness R1W in the first direction D1 of the first part R1 and a thickness R3W in the first direction D1 of the third part R3. The thickness R2W in the first direction D1 of the second part R2 may be 1.2 times to 1.3 times (e.g., about 1.2 times to about 1.3 times) the thickness R1W in the first direction D1 of the first part R1 and/or the thickness R3W in the first direction D1 of the third part R3.

A thickness W2 in the first direction D1 of the second oxide semiconductor pattern 142 in the second part R2 may be less than a thickness R1W in the first direction D1 of the second oxide semiconductor pattern 142 in the first part R1 and a thickness R3W in the first direction D1 of the second oxide semiconductor pattern 142 in the third part R3. The thickness W2 in the first direction D1 of the second oxide semiconductor pattern 142 in the second part R2 may be less than a thickness W4 in the first direction D1 of the first oxide semiconductor pattern 141 in the second part R2.

Gate electrodes GE may be formed on and cross (or intersect) the bit lines BL and the first lower dielectric patterns 110. The gate electrodes GE may extend in the second direction D2 and may be spaced apart from each other in the first direction D1. The gate electrodes GE may be disposed on lateral surfaces of the mold structures MS. The gate electrodes GE may be spaced apart from each other in the first direction D1 across (or facing) a corresponding one of the mold structures MS. The vertical semiconductor pattern VSP may be interposed between the gate electrode GE and the lateral surfaces of the mold structures MS. A pair of gate electrodes GE may be disposed between a pair of mold structures MS that are immediately adjacent each other (e.g., in the first direction D1). A pair of gate electrodes GE may be formed on and cross (or intersect) the horizontal semiconductor pattern HSP. The gate electrodes GE may be word lines. For each gate electrode GE, a central portion (e.g., in the third direction D3) may overlap (e.g., in the first direction D1) the second part R2 of the adjacent vertical semiconductor pattern VSP. The term "overlap" (or "overlapping", or like terms), as may be used herein, is intended to broadly refer to a first element that intersects with at least a portion of a second element in a particular direction, but does not necessarily require that the first and second elements be completely aligned with one another; that is, components or layers described with reference to "overlap" in a particular direction may be at least partially obstructed by one another when viewed along a line extending in the particular direction.

The gate electrodes GE may include a conductive material, such as at least one of metal (e.g., Ti, Mo, W, Cu, Al, Ta, Ru, Ir, or Co), metal silicide (e.g., silicide of Ti, Mo, W, Cu, Al, Ta, Ru, Ir, or Co), and conductive metal nitride (e.g., nitride of Ti, Mo, W, Cu, Al, Ta, Ru, Ir, or Co).

A gate dielectric pattern GI may be interposed between the mold structure MS and the gate electrode GE. The gate dielectric pattern GI may be interposed between the gate electrode GE and the lateral surface of the mold structure MS, and may extend between the vertical semiconductor pattern VSP and the gate electrode GE. The gate dielectric pattern GI may extend between the gate electrode GE and the horizontal semiconductor pattern HSP. The gate dielectric pattern GI may extend between the first lower dielectric pattern 110 and the gate electrode GE. The gate dielectric pattern GI may have a crooked shape or a stepped structure (or profile) on a lateral surface of the vertical semiconductor pattern VSP. The crooked shape or stepped structure (or profile) may be present on at least one of the second part R2 of the vertical semiconductor pattern VSP, a boundary between the first part R1 and the second part R2, and a boundary between the second part R2 and the third part R3. For the purposes of discussion herein, a crooked shape or stepped structure of the gate dielectric pattern GI may indicate that a surface of the gate dielectric pattern GI is at two different levels that are connected by an edge.

The gate dielectric pattern GI may include a first gate dielectric pattern GI1 and a second gate dielectric pattern GI2. The first gate dielectric pattern GI1 may be interposed between the vertical semiconductor pattern VSP and the gate electrode GE, and may extend between the horizontal semiconductor pattern HSP and the gate electrode GE. The second gate dielectric pattern GI2 may be interposed between the first gate dielectric pattern GI1 and the gate electrode GE, and may extend between the gate electrode GE and the lateral surface of each of the mold structures MS. The second gate dielectric pattern GI2 may extend between each of the first lower dielectric patterns 110 and each of the gate electrodes GE, and may further extend onto a top surface of each of the mold structures MS.

An interface may be present or absent between the first gate dielectric pattern GI1 and the second gate dielectric pattern GI2. For instance, if the first gate dielectric pattern GI1 and the second gate dielectric pattern GI2 are formed of different materials, then there may be an interface between the first gate dielectric pattern GI1 and the second gate dielectric pattern GI2. Alternatively, if the first gate dielectric pattern GI1 and the second gate dielectric pattern GI2 are formed of the same material, then there may be no interface between the first gate dielectric pattern GI1 and the second gate dielectric pattern GI2 (e.g., they may form a single, unbroken structure). The gate dielectric pattern GI may include, for example at least one of silicon oxide and high-k dielectric materials. For the purposes of discussion herein, the high-k dielectric material may refer to a material having a dielectric constant greater than that of silicon oxide.

A buried dielectric layer 160 may be interposed between the mold structures MS, and may cover top surfaces and lateral surfaces of the gate electrodes GE. The buried dielectric layer 160 may be disposed between the gate electrode GE on the lateral surface of one of a pair of mold structures MS and the gate electrode GE on the lateral surface of the other of a pair of mold structures MS, and may extend onto the top surfaces of the gate electrodes GE. The gate dielectric pattern GI may extend between the buried dielectric layer 160 and the lateral surface of the mold structure MS. The gate dielectric pattern GI may extend between the buried dielectric layer 160 and each of the first lower dielectric patterns 110.

A capping dielectric layer 150 may be interposed between the buried dielectric layer 160 and each of the gate electrodes GE. The capping dielectric layer 150 may be interposed between the buried dielectric layer 160 and the top surface of each of the gate electrodes GE, and may extend between the buried dielectric layer 160 and the lateral surface of each of the gate electrodes GE. The capping dielectric layer 150 may extend onto the horizontal semiconductor pattern HSP between the gate electrode GE on the lateral surface of one of a pair of mold structures MS and the gate electrode GE on the lateral surface of the other of a pair of mold structures MS, and may be interposed between the buried dielectric layer 160 and the gate dielectric pattern GI on the horizontal semiconductor pattern HSP.

The capping dielectric layer 150 may extend between the buried dielectric layer 160 and the gate dielectric pattern GI on the lateral surface of each of the mold structures MS. The capping dielectric layer 150 may extend onto the top surface of each of the mold structures MS, and the gate dielectric pattern GI may be interposed between the capping dielectric layer 150 and the top surface of each of the mold structures MS. The buried dielectric layer 160 may include, for example, a silicon oxide layer, a silicon nitride layer, a silicon oxynitride, and/or a low-k dielectric layer. The capping dielectric layer 150 may include a dielectric material (e.g., silicon nitride) different from that of the buried dielectric layer 160.

A first upper dielectric layer 170 (FIGS. 5 and 6) may be disposed on the mold structures MS and the buried dielectric layer 160. The first upper dielectric layer 170 may cover the capping dielectric layer 150 on the top surfaces of the mold structures MS, and may also cover the top surface of the buried dielectric layer 160. A second upper dielectric layer 180 may be disposed on the first upper dielectric layer 170, and may cover a top surface of the first upper dielectric layer 170. The first upper dielectric layer 170 and the second upper dielectric layer 180 may include, for example, a silicon oxide layer, a silicon nitride layer, a silicon oxynitride layer, and/or a low-k dielectric layer.

Node contacts 175 may be correspondingly disposed on the vertical semiconductor patterns VSP. Each of the node contacts 175 may penetrate the first upper dielectric layer, the capping dielectric layer 150, and the gate dielectric pattern GI, and may be electrically connected to a corresponding one of the vertical semiconductor patterns VSP. Each of the node contacts 175 may be in contact with a top surface of a corresponding one of the vertical semiconductor patterns VSP.

Landing pads LP may be correspondingly disposed on the node contacts 175. Each of the landing pads LP may penetrate the second upper dielectric layer 180, and may be electrically connected to a corresponding one of the node contacts 175. The landing pads LP may be correspondingly in contact with top surfaces of the node contacts 175, and when viewed in plan, may have a circular shape, an oval shape, a rectangular shape, a square shape, a rhombic shape, a hexagonal shape, or any other suitable shape.

The node contacts 175 and the landing pads LP may include the same conductive material. For example, the node contacts 175 and the landing pads LP may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or any combination thereof, but the example embodiments are not limited thereto. In IrOx and RuOx, x represents a relative amount of oxygen (e.g., IrO2, Ir2O3, IrO4, RuO2, RuO4, etc.).

Data storage patterns DS may be correspondingly disposed on the landing pads LP. The data storage pattern DS may correspond to the date storage element DS of FIG. 1. The data storage patterns DS may be correspondingly electrically connected to the vertical semiconductor patterns VSP through the landing pads LP and the node contacts 175. The data storage patterns DS may be arranged spaced apart from each other along the first direction D1 and the second direction D2. According to some example embodiments, the data storage patterns DS may be or include capacitors (e.g., the semiconductor device may be a dynamic random access memory device (DRAM)). The data storage patterns DS may include bottom electrodes that are correspondingly disposed on the landing pads LP, a top electrode that covers the bottom electrodes, and a dielectric layer between the top electrode and each of the bottom electrodes. According to some example embodiments, the data storage patterns DS may be variable resistance patterns each of which is switchable between two resistance states by an electrical pulse. In addition or alternatively, the data storage patterns DS may include a phase-change material whose crystalline state is changed based on an amount of current, perovskite compounds, transition metal oxide, magnetic materials, ferromagnetic materials, or antiferromagnetic materials. Accordingly, the semiconductor device may be any form of memory device, and is not limited to DRAM.

According to some example embodiments of the inventive concepts, the vertical semiconductor pattern VSP may include an oxide semiconductor, and the first part R1 and the third part R3 may have conductivities that are relatively higher than that of the second part R2. This may be because the first oxide semiconductor pattern 141 is disposed in the second part R2, and the second oxide semiconductor pattern 142 is disposed in the first and third parts R1 and R3. The second oxide semiconductor pattern 142 may have a higher electrical conductivity than the first oxide semiconductor pattern 141. As a result, a contact resistance may be reduced at an interface between the first part R1 and the bit line BL and at an interface between the third part R3 and the node contact 175. In addition, the second part R2 may exhibit increased reliability, such as a reduction in degradation (e.g., change in threshold voltage, ΔVₜₕ) caused by positive bias temperature instability (PBTI) and negative bias temperature instability (NBTI). Accordingly, electrical properties of a vertical channel transistor may be improved.

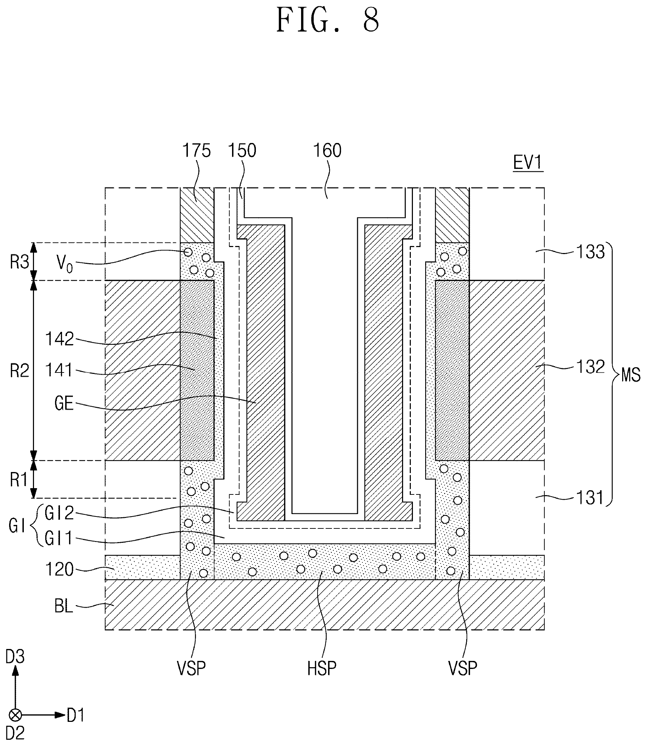

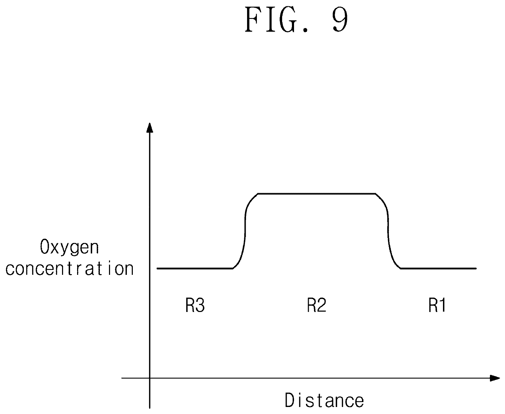

FIG. 8 illustrates a cross-sectional view conceptually showing FIG. 7. FIG. 9 illustrates a graph showing oxygen concentrations of R1, R2, and R3 of FIG. 8.

Referring to FIG. 8, each of the first oxide semiconductor pattern 141 and the second oxide semiconductor pattern 142 may include InGaZnO. An oxygen concentration of the first oxide semiconductor pattern 141 may be greater than an oxygen concentration of the second oxide semiconductor pattern 142. A concentration of oxygen vacancies Vo in the second oxide semiconductor pattern 142 may be greater than a concentration of oxygen vacancies Vo in the first oxide semiconductor pattern 141. The oxygen vacancy Vo may serve as a carrier.

Referring to FIG. 9, it may be ascertained that the second part R2 has an oxygen concentration greater than that of the first part R1 and the third part R3. For example, the oxygen concentrations of the first, second, and third parts R1, R2, and R3 may be compared with each other by energy dispersive X-ray spectroscopy (EDS), electron energy loss spectroscopy (EELS), and/or secondary ion mass spectroscopy (SIMS). In addition, it may be possible to compare the oxygen vacancy concentrations of the first, second, and third parts R1, R2, and R3.

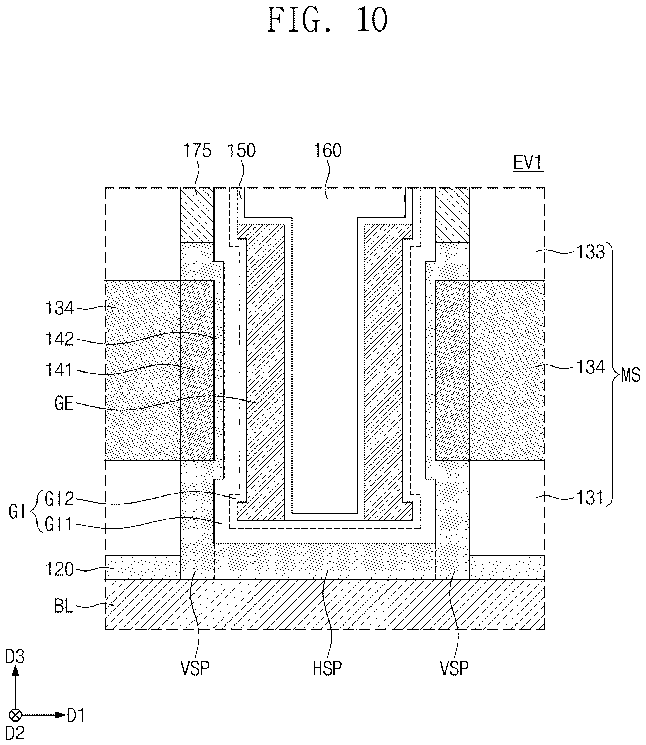

FIG. 10 illustrates an enlarged view showing section EV1 of FIG. 5.

Referring to FIG. 10, according to some example embodiments, the mold structure MS may be configured such that the first mold pattern 131 and the third mold pattern 133 are provided with a fourth mold pattern 134 therebetween in place of the second mold pattern 132. The fourth mold pattern 134 may correspond to the second mold pattern 132 discussed above.

The fourth mold pattern 134 may include a dielectric material. The fourth mold pattern 134 may include a dielectric material different from those of the first mold pattern 131 and the second mold pattern 132. For example, the first mold pattern 131 and the second mold pattern 132 may include silicon nitride, and the fourth mold pattern 134 may include silicon oxide.

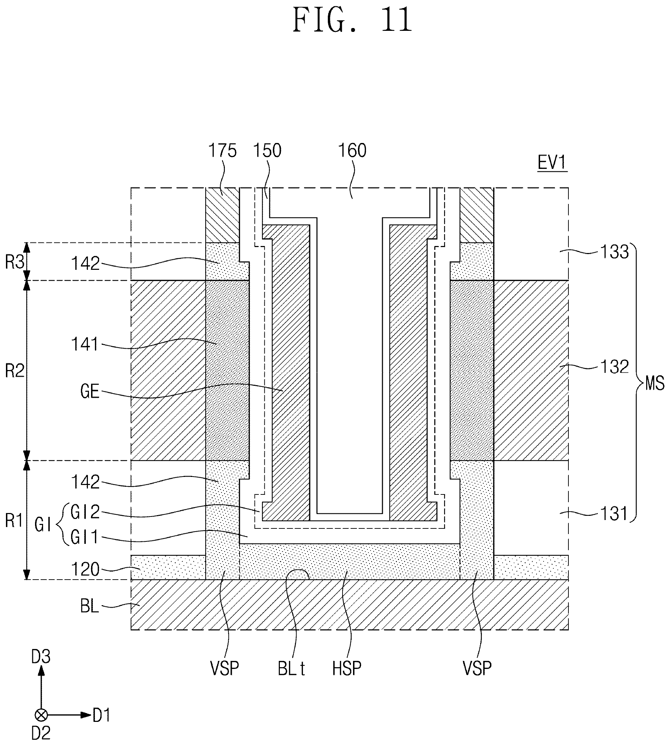

FIG. 11 illustrates an enlarged view showing section EV1 of FIG. 5.

Referring to FIG. 11, the second part R2 of the vertical semiconductor pattern VSP may not include the second oxide semiconductor pattern 142. The first oxide semiconductor pattern 141 may be in contact with the gate dielectric pattern GI. The second oxide semiconductor pattern 142 of the first part R1 may be spaced apart from the second oxide semiconductor pattern 142 of the third part R3 across the first oxide semiconductor pattern 141 of the second part R2.

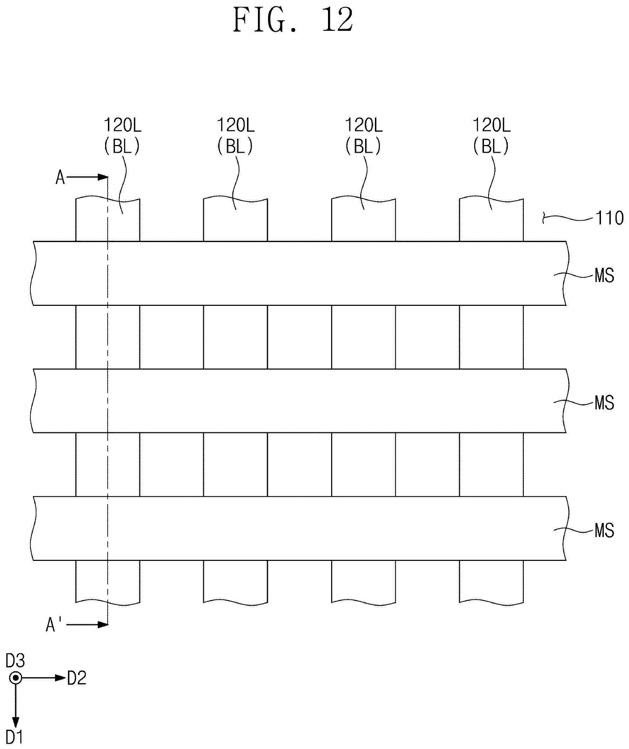

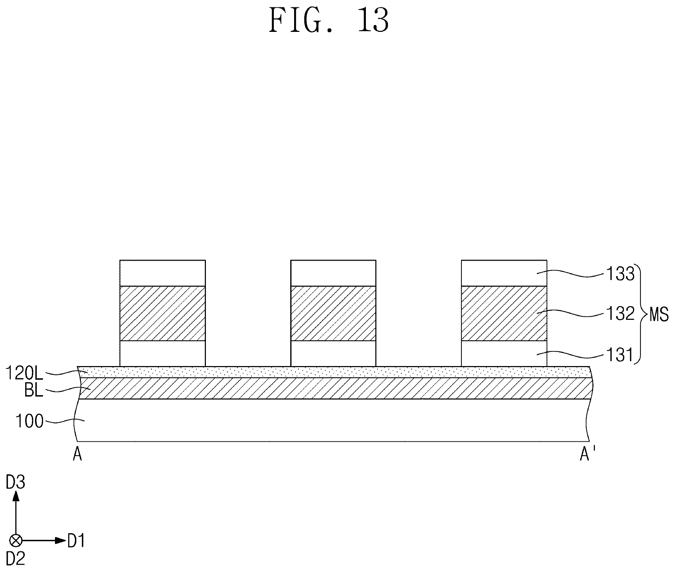

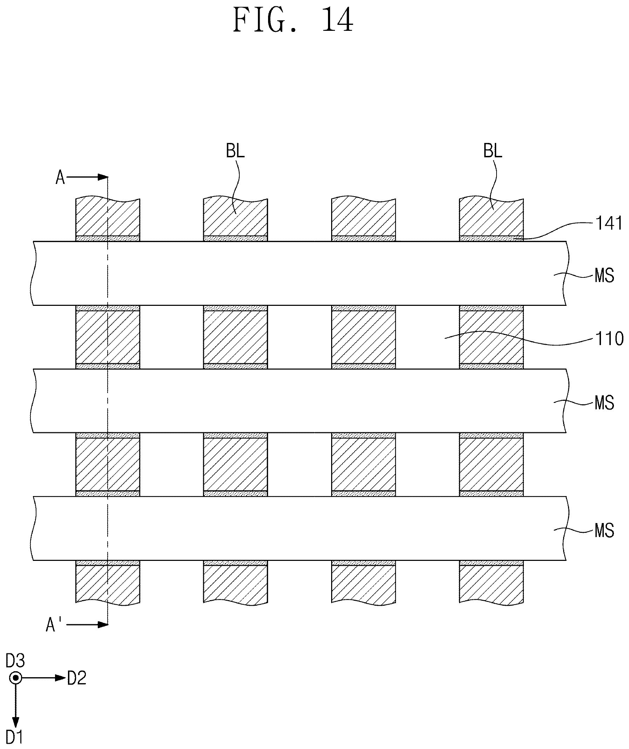

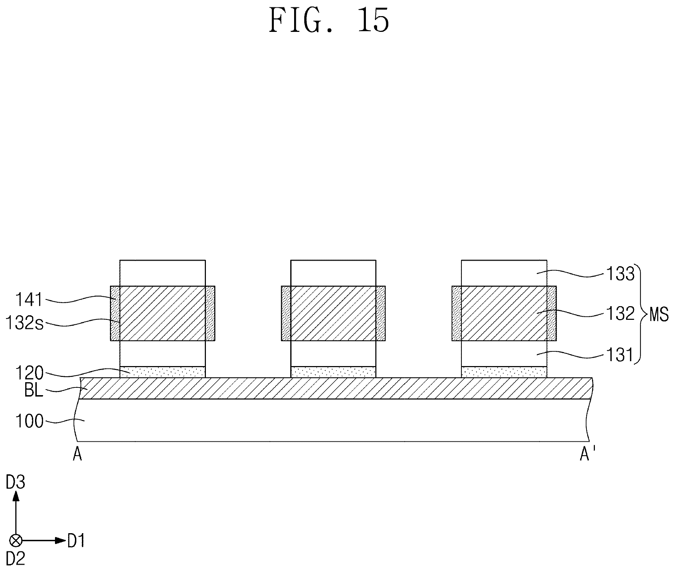

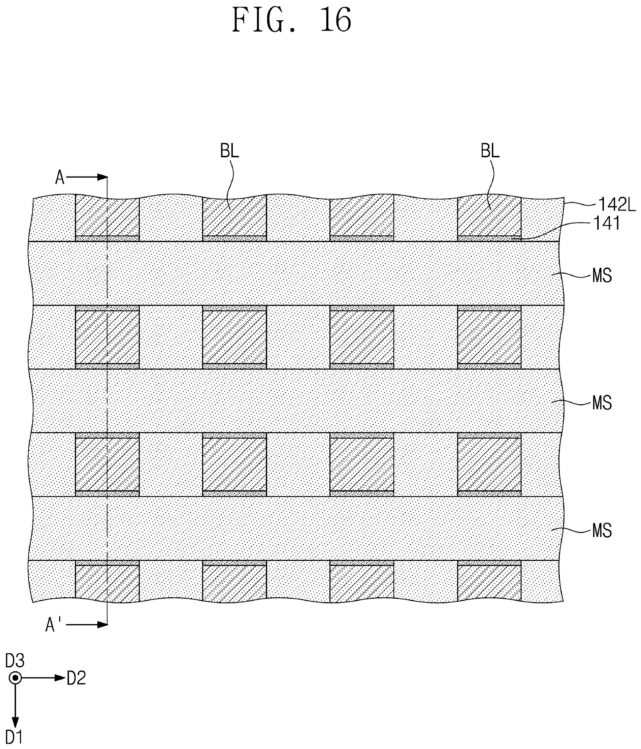

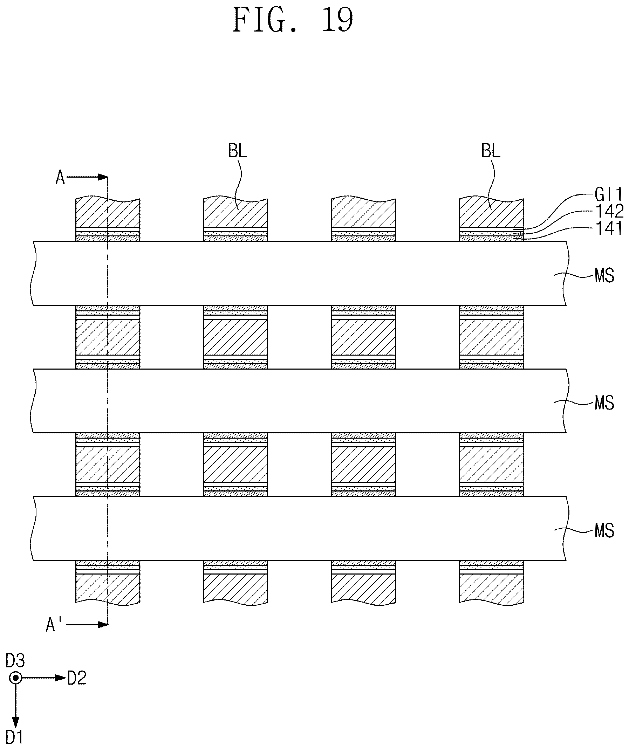

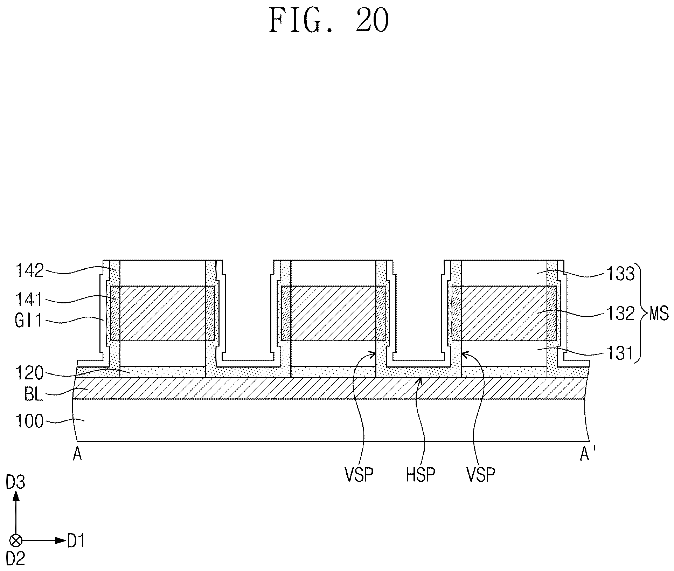

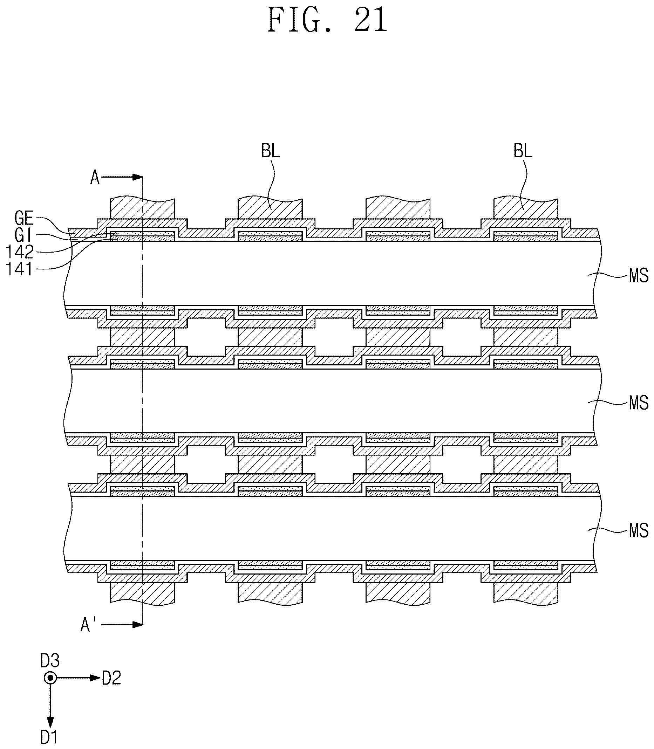

FIGS. 12, 14, 16, 19, and 21 illustrate plan views showing a method of fabricating a semiconductor device according to some example embodiments of the inventive concepts. FIGS. 13, 15, 17, 18, 20, 22, 23, and 24 illustrate cross-sectional views showing a method of fabricating a semiconductor device according to some example embodiments of the inventive concepts. FIG. 13 illustrates a cross-sectional view taken along line A-A' of FIG. 12, FIG. 15 illustrates a cross-sectional view taken along line A-A' of FIG. 14, FIGS. 17 and 18 illustrate cross-sectional views taken along line A-A' of FIG. 16, FIG. 20 illustrates a cross-sectional view taken along line A-A' of FIG. 19, and FIGS. 22, 23, and 24 illustrate cross-sectional views taken along line A-A' of FIG. 21. The method of fabricating the semiconductor device in FIGS. 12-24 may be best understood with reference to FIGS 4-11, and the discussion of the semiconductor device in FIGS. 4 to 11 may be omitted herein for the sake of brevity.

Referring to FIGS. 12 and 13, bit lines BL may be formed on a substrate 100. The formation of the bit lines BL may include, for example, forming a conductive layer on the substrate 100, and patterning the conductive layer. The bit lines BL may extend in the first direction D1 and may be spaced apart from each other in the second direction D2. First lower dielectric patterns 110 may be formed between the bit lines BL, and may extend in the first direction D1 between the bit lines BL. The formation of the first lower dielectric patterns 110 may include, for example, forming a dielectric layer that covers the bit lines BL and fills a space between the bit lines BL, and planarizing the dielectric layer until top surfaces of the bit lines BL are exposed.

A lower dielectric line 120L may be formed on the bit lines BL. The formation of the lower dielectric line 120L may include, for example, forming a dielectric layer that covers the bit lines BL and the first lower dielectric patterns 110, forming a mask that covers the bit lines BL and exposes the first lower dielectric patterns 110, removing the dielectric layer on the first lower dielectric patterns 110, and removing the mask. The lower dielectric line 120L may include a dielectric material having an etch selectivity with respect to a first mold pattern 131 and a third mold pattern 133 which will be discussed below.

Mold structures MS may be formed to cross over the lower dielectric line 120L and the first lower dielectric patterns 110. The mold structures MS may extend in the second direction D2 and may be spaced apart from each other in the first direction D1.

Each of the mold structures MS may include a first mold pattern 131, a second mold pattern 132, and a third mold pattern 133 that are stacked in the third direction D3. The formation of the mold structures MS may include, for example, sequentially stacking first to third mold layers on the bit lines BL and the first lower dielectric patterns 110, and sequentially patterning the first to third mold layers.

Referring to FIGS. 14 and 15, a first oxide semiconductor pattern 141 may be formed on a lateral surface 132s of the second mold pattern 132. For example, an inhibitor configured to attach to a dielectric material, but not to a metallic material, may be provided on the mold structure MS, the lower dielectric line 120L, and the first lower dielectric pattern 110. The inhibitor may be attached to the first mold pattern 131 including a dielectric material, the third mold pattern 133, the lower dielectric line 120L, and the first lower dielectric pattern 110. In contrast, the inhibitor may not be attached to the second mold pattern 132 including metal. A precursor and a reactant may be provided to deposit an oxide semiconductor on a lateral surface of the second mold pattern 132. The inhibitor may prevent the formation of the oxide semiconductor on its surface. After the oxide semiconductor is formed on the lateral surface of the second mold pattern 132, the inhibitor may be removed. The lower dielectric line 120L may be disposed on the bit line BL, and thus the inhibitor may be prevented from being attached to the bit line BL.

For another example, a precursor configured to attach to metal, but not to a dielectric material, may be provided on the mold structure MS, the lower dielectric line 120L, and the first lower dielectric pattern 110. The precursor may not be attached to any of the first mold pattern 131 including a dielectric material, the third mold pattern 133, the lower dielectric line 120L, and the first lower dielectric pattern 110. In contrast, the precursor may be attached to the second mold pattern 132 including metal. A reactant may be provided to deposit an oxide semiconductor on a lateral surface of the second mold pattern 132. The lower dielectric line 120L may be disposed on the bit line BL, and thus the precursor may be prevented from being attached to the bit line BL.

The deposition process may include, for example, chemical vapor deposition (CVD) and/or atomic layer deposition (ALD). The area selective deposition (ASD) may be performed using one or more known techniques in the art.

According to some example embodiments, a fourth mold pattern 134 may be used instead of the second mold pattern 132 (see FIG. 10). The fourth mold pattern 134 may include a dielectric material. The first mold pattern 131 may include a dielectric material the same as that of the third mold pattern 133 and different from that of the fourth mold pattern 134. For example, the first mold pattern 131 and the third mold pattern 133 may include silicon nitride, and the fourth mold pattern 134 may include silicon oxide. Likewise, as discussed above, even in this case, an inhibitor may be attached to portions except for the fourth mold pattern 134 or a precursor may be selectively attached only to the fourth mold pattern 134, and therefore a first oxide semiconductor pattern 141 may be formed on a lateral surface of the fourth mold pattern 134.

After the formation of the first oxide semiconductor pattern 141, the lower dielectric line 120L of FIGS. 12 and 13 may be patterned to form a second lower dielectric pattern 120. For example, a wet etching process may be used to pattern the lower dielectric line 120L. It may be possible to remove the lower dielectric line 120L on the bit line BL exposed from the mold structure MS, and keep the lower dielectric line 120L between the mold structure MS and the bit line BL.

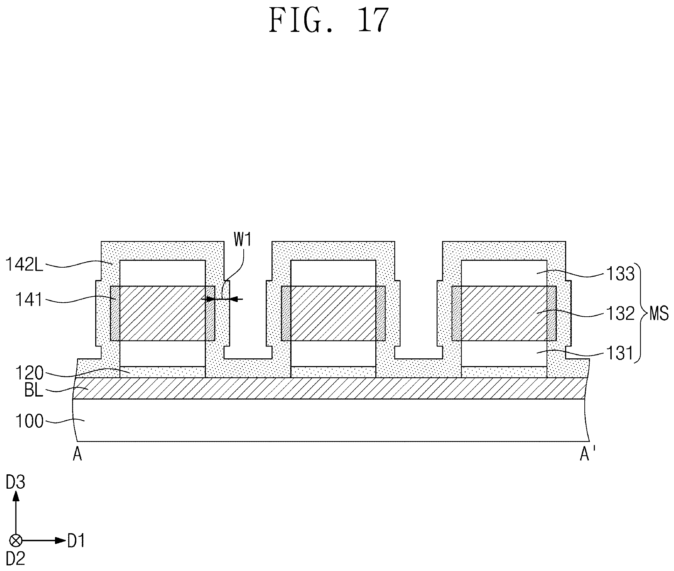

Referring to FIGS. 16 and 17, an oxide semiconductor layer 142L may be formed on a front surface of the substrate 100. The oxide semiconductor layer 142L may cover a top surface and a lateral surface of the mold structure MS, a top surface, a lateral surface and a bottom surface of the first oxide semiconductor pattern 141, and top surfaces of the bit lines BL and the first lower dielectric patterns 110 between the mold structures MS. The oxide semiconductor layer 142L and the first oxide semiconductor pattern 141 may include oxide semiconductors having the same composition of elements other than oxygen. For example, the oxide semiconductor layer 142L may include an oxide semiconductor whose oxygen concentration is less than that of an oxide semiconductor included in the first oxide semiconductor pattern 141. For example, the difference in oxygen concentration between the first oxide semiconductor pattern 141 and the oxide semiconductor layer 142L may depend on a concentration of an oxidizer (e.g., ozone) and/or a flow rate of oxygen in the procedure of forming the first oxide semiconductor pattern 141 and the oxide semiconductor layer 142L.

According to some example embodiments, the oxide semiconductor layer 142L and the first oxide semiconductor pattern 141 may include oxide semiconductors having the same elements and different compositions. According to some example embodiments, the first oxide semiconductor pattern 141 and the oxide semiconductor layer 142L may include oxide semiconductors that differ in one or more elements.

The oxide semiconductor layer 142L may conformally extend and have a substantially constant thickness W1. When the oxide semiconductor layer 142L includes the same material as that of the first oxide semiconductor pattern 141, an invisible interface may be present between the first oxide semiconductor pattern 141 and the oxide semiconductor layer 142L. The first oxide semiconductor pattern 141 interposed between the second mold patterns 132 may cause the oxide semiconductor layer 142L positioned on the lateral surface of the second mold pattern 132 to protrude in the first direction D1 from the oxide semiconductor layer 142L positioned on a lateral surface of the first mold pattern 131 and/or the oxide semiconductor layer 142L positioned on a lateral surface of the third mold pattern 133.

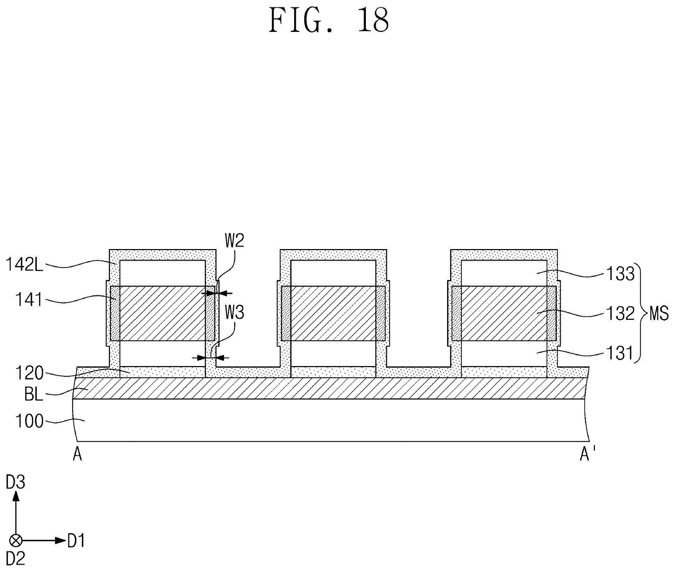

Referring to FIG. 18, a thickness of the oxide semiconductor layer 142L may be reduced (e.g., a trimming process). For example, a wet etching process may be employed to reduce the thickness of the oxide semiconductor layer 142L. In the wet etching process, the oxide semiconductor layer 142L positioned on the lateral surface of the second mold pattern 132 may be more actively etched than the oxide semiconductor layer 142L positioned on the lateral surface of the first mold pattern 131 and/or the oxide semiconductor layer 142L positioned on the lateral surface of the third mold pattern 133. Therefore, after the etching process, a thickness W2 of the oxide semiconductor layer 142L positioned on the lateral surface of the second mold pattern 132 may be less than a thickness W3 of the oxide semiconductor layer 142L positioned on the lateral surface of the first mold pattern 131 and/or a thickness W3 of the oxide semiconductor layer 142L positioned on the lateral surface of the third mold pattern 133 (see FIG. 7). According to some example embodiments, the oxide semiconductor layer 142L positioned on the lateral surface of the second mold pattern 132 may be completely removed (see FIG. 11).

Referring to FIGS. 19 and 20, there may be formed a vertical semiconductor pattern VSP, a horizontal semiconductor pattern HSP, and a first gate dielectric pattern GI1.

The formation of the vertical semiconductor pattern VSP, the horizontal semiconductor pattern HSP, and the first gate dielectric pattern GI1 may include forming a first gate dielectric layer on the oxide semiconductor layer 142L of FIG. 18, removing the first gate dielectric layer on the first lower dielectric patterns 110 except for the first gate dielectric layer on the mold structure MS and the bit line BL, and planarizing the first dielectric layer until a top surface of the third mold pattern 133 of the mold structure MS is exposed. As a result of the planarization, oxide semiconductor layer 142L may be formed into a plurality of second oxide semiconductor patterns 142 that are separated from each other, and the first gate dielectric layer may be formed into a plurality of first gate dielectric patterns GI1 that are separated from each other.

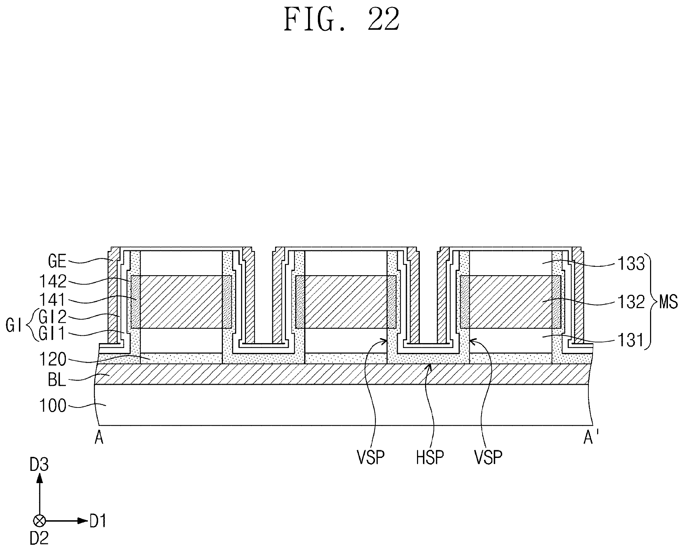

Referring to FIGS. 21 and 22, a second gate dielectric pattern GI2 may be formed to cover the mold structures MS and to also cover the bit lines BL and the first lower dielectric patterns 110 between the mold structures MS. The second gate dielectric pattern GI2 may conformally cover a lateral surface and a top surface of each of the mold structures MS, and may also conformally cover the top surfaces of the bit lines BL and the first lower dielectric patterns 110 between the mold structures MS. The second gate dielectric pattern GI2 may cover the vertical semiconductor pattern VSP and the first gate dielectric pattern GI1. The second gate dielectric pattern GI2 may cover the horizontal semiconductor pattern HSP and the first gate dielectric pattern GI1. The first gate dielectric pattern GI1 and the second gate dielectric pattern GI2 may be collectively called a gate dielectric pattern GI.

Gate electrodes GE may be formed on the bit lines BL and the first lower dielectric patterns 110. The formation of the gate electrodes GE may include, for example, forming on the bit lines BL and the first lower dielectric patterns 110 a gate electrode layer that covers the mold structures MS, and performing an anisotropic etching process on the gate electrode layer. The anisotropic etching process may be executed to allow the gate electrodes GE to locally remain on the lateral surfaces of the mold structures MS.

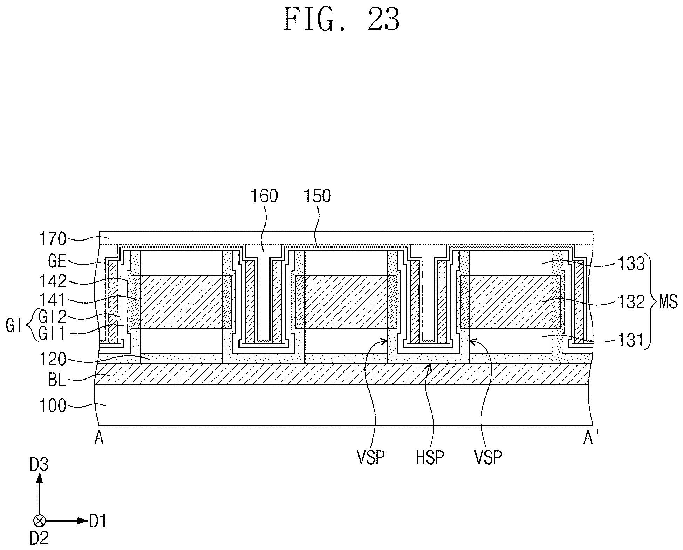

Referring to FIGS. 21 and 23, upper portions of the gate electrodes GE may be recessed. Afterwards, a capping dielectric layer 150 may be formed to cover the mold structures MS and the gate electrodes GE. The capping dielectric layer 150 may cover the gate dielectric pattern GI on the top surfaces of the mold structures MS and the gate dielectric pattern GI on upper lateral surfaces of the mold structures MS. The capping dielectric layer 150 may extend to cover top surfaces and lateral surfaces of the gate electrodes GE, and may also extend to cover the gate dielectric pattern GI between the mold structures MS and between the gate electrodes GE.

A buried dielectric layer 160 may be formed on the capping dielectric layer 150, and may fill a space between the mold structures MS. The buried dielectric layer 160 may extend between the gate electrodes GE. The formation of the buried dielectric layer 160 may include, for example, forming a dielectric layer that covers the mold structures MS and the gate electrodes GE and planarizing the dielectric layer until the capping dielectric layer 150 on the top surfaces of the mold structures MS is exposed.

A first upper dielectric layer 170 may be formed on the mold structures MS and the buried dielectric layer 160. The first upper dielectric layer 170 may cover the capping dielectric layer 150 on the top surfaces of the mold structures MS, and may also cover a top surface of the buried dielectric layer 160.

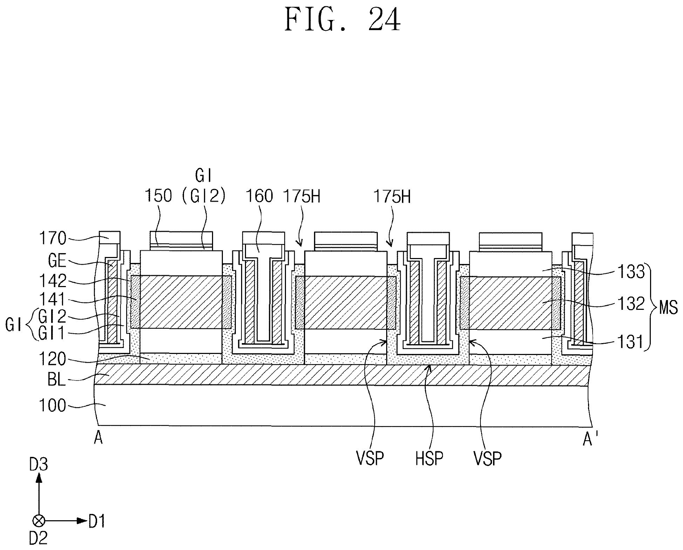

Referring to FIGS. 21 and 24, node contact holes 175H may be formed in the first upper dielectric layer 170. Each of the node contact holes 175H may penetrate the first upper dielectric layer 170, the capping dielectric layer 150, and the gate dielectric pattern GI, and may expose a corresponding one of the vertical semiconductor patterns VSP. Upper portions of the vertical semiconductor patterns VSP exposed by the node contact holes 175H may be recessed, and thus each of the node contact holes 175H may extend between the gate dielectric pattern GI and the lateral surface of one of the mold structures MS.

Referring back to FIGS. 4 to 6, node contacts 175 may be correspondingly formed in the node contact holes 175H, and landing pads LP may be correspondingly formed on the node contacts 175. The formation of the node contacts 175 and the landing pads LP may include, for example, forming on the first upper dielectric layer 170 an upper conductive layer that fills the node contact holes 175H and extends onto the first upper dielectric layer 170, and patterning the upper conductive layer. The upper conductive layer may be patterned to form the landing pads LP, and the upper conductive layer filling the node contact holes 175H may be called node contacts 175.

A second upper dielectric layer 180 may be formed to fill a space between the landing pads LP. The formation of the second upper dielectric layer 180 may include, for example, forming on the first upper dielectric layer 170 the second upper dielectric layer 180 that covers the landing pads LP, and planarizing the second upper dielectric layer 180 until top surfaces of the landing pads LP are exposed. Data storage patterns DS may be correspondingly formed on the exposed top surfaces of the landing pads LP.

According to some example embodiments of the inventive concepts, a vertical semiconductor pattern may include edge parts (e.g., end parts) in contact with a bit line and a node contact, and the edge parts of the vertical semiconductor pattern may include an oxide semiconductor whose oxygen concentration is less than that of a channel part of the vertical semiconductor pattern. Thus, there may be a reduction in interfacial resistance between the vertical semiconductor pattern and the node contact and in interfacial resistance between the vertical semiconductor pattern and the bit line. In addition, as the oxygen concentration of the channel part is greater than that of the edge parts, there may be an improvement in reliability. Example embodiments discussed herein thus provide a semiconductor device including vertical channel transistors having improved electrical properties.

While the application discusses semiconductor memory devices (e.g., including data storage patterns), the advantages described herein may be achieved in any form of semiconductor device (e.g., any form of semiconductor device having a vertical semiconductor pattern). Accordingly, the application is not limited to memory devices.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Embodiments are set out in the following Clauses:
Clause 1. A semiconductor device, comprising:
   a substrate;
   a bit line extending in a first direction on the substrate;
   a mold structure on the bit line and extending in a second direction that intersects the first direction;
   a vertical semiconductor pattern on a top surface of the bit line and a lateral surface of the mold structure;
   a gate electrode spaced apart from the mold structure and facing the vertical semiconductor pattern and extending in the second direction that intersects the bit line; and
   a node contact on the vertical semiconductor pattern,
      wherein the mold structure comprises a first mold pattern, a second mold pattern, and a third mold pattern that are sequentially stacked on the bit line,
      wherein the second mold pattern comprises a material different from a material of the first mold pattern and a material of the third mold pattern, and
      wherein a thickness of the second mold pattern is greater than a thickness of the first mold pattern.
Clause 2. The semiconductor device of Clause 1, wherein the second mold pattern overlaps a central portion of the gate electrode in the first direction.
Clause 3. The semiconductor device of Clause 1 or Clause 2, wherein the first mold pattern and the third mold pattern comprise a same dielectric material.
Clause 4. The semiconductor device of any of Clauses 1-3, wherein the second mold pattern comprises metal.
Clause 5. The semiconductor device of any of Clause 1-3, wherein
   the first mold pattern and the third mold pattern comprise one of silicon oxide and silicon nitride, and
   the second mold pattern comprises the other of the silicon oxide and the silicon nitride.
Clause 6. The semiconductor device of any preceding Clause, further comprising a lower dielectric pattern between the first mold pattern and the bit line,
   wherein the lower dielectric pattern comprises a dielectric material different from a dielectric material of the first mold pattern and a dielectric material of the third mold pattern.
Clause 7. The semiconductor device of any preceding Clause, wherein a thickness of the lower dielectric pattern is less than a thickness of the first mold pattern.
Clause 8. A semiconductor device, comprising:
   a substrate;
   a bit line extending in a first direction on the substrate;
   a mold structure on the bit line and extending in a second direction that intersects the first direction;
   a vertical semiconductor pattern on a top surface of the bit line and a lateral surface of the mold structure;
   a gate electrode spaced apart from the mold structure and facing the vertical semiconductor pattern and extending in the second direction that intersects the bit line; and
   a node contact on the vertical semiconductor pattern,
      wherein the mold structure comprises a first mold pattern, a second mold pattern, and a third mold pattern that are sequentially stacked on the bit line,
      wherein the vertical semiconductor pattern comprises a first part, a second part, and a third part that are sequentially on the bit line,
      wherein the first part is on a lateral surface of the first mold pattern,
      wherein the second part is on a lateral surface of the second mold pattern,
      wherein the third part is on a lateral surface of the third mold pattern,
      wherein the first part contacts the bit line,
      wherein the third part contacts the node contact, and
      wherein the second mold pattern comprises metal.
Clause 9. The semiconductor device of Clause 8, wherein the vertical semiconductor pattern comprises a first oxide semiconductor pattern and a second oxide semiconductor pattern,
   wherein the first oxide semiconductor pattern is on the second part,
   wherein the second oxide semiconductor pattern is on each of the first part and the third part, and
   wherein an oxygen concentration of the first oxide semiconductor pattern is greater than an oxygen concentration of the second oxide semiconductor pattern.
Clause 10. The semiconductor device of Clause 9, wherein the second oxide semiconductor pattern extends on a lateral surface of the first oxide semiconductor pattern and is spaced apart from the second mold pattern and faces the first oxide semiconductor pattern.

While several embodiments have been provided in the present disclosure, it should be understood that the disclosed systems and methods might be embodied in many other specific forms without departing from the scope of the present disclosure. The present examples are to be considered as illustrative and not restrictive, and the intention is not to be limited to the details given herein. For example, the various elements or components may be combined or integrated in another system or certain features may be omitted, or not implemented.

## Claims

1. A semiconductor device, comprising:
a substrate (100);
a bit line (BL) extending in a first direction on the substrate (100);
a mold structure (MS) on the bit line (BL) and extending in a second direction that intersects the first direction;
a vertical semiconductor pattern (VSP) on a top surface (BLt) of the bit line (BL) and a lateral surface (131s) of the mold structure (MS);
a gate electrode (GE) spaced apart from the mold structure (MS) and facing the vertical semiconductor pattern (VSP) and extending in the second direction that intersects the bit line; and
a node contact (175) on the vertical semiconductor pattern (VSP),
wherein the vertical semiconductor pattern (VSP) comprises a first part, a second part, and a third part that are sequentially on the bit line, and
wherein a distance (R2W) that the second part protrudes from the lateral surface (131s) of the mold structure (MS) is more than a distance (R1W, R3W) that the first part and the third part protrude from the lateral surface (131s).

2. The semiconductor device of claim 1, wherein
the second part comprises a first oxide semiconductor, and
the first part and the third part comprise a second oxide semiconductor.

3. The semiconductor device of claim 2, wherein
the first oxide semiconductor and the second oxide semiconductor comprise a same element, and
an oxygen concentration of the first oxide semiconductor is greater than an oxygen concentration of the second oxide semiconductor.

4. The semiconductor device of claim 2, wherein elements included in the second oxide semiconductor differ by at least one from elements included in the first oxide semiconductor.

5. The semiconductor device of claim 2, wherein the first oxide semiconductor and the second oxide semiconductor comprise same elements and have different compositions.

6. The semiconductor device of any preceding claim, wherein
the first part contacts the bit line (BL), and
the third part contacts the node contact (175).

7. The semiconductor device of any preceding claim, wherein a thickness (R2W) of the second part in the first direction is greater than a thickness (R3W) of the third part in the first direction.

8. The semiconductor device of any preceding claim, wherein a height of the second part is greater than a height of the first part.

9. The semiconductor device of any preceding claim, further comprising a gate dielectric pattern (GI) between the vertical semiconductor pattern (VSP) and the gate electrode (GE),
wherein the gate dielectric pattern (GI) has a stepped structure on a lateral surface of the vertical semiconductor pattern (VSP).

10. The semiconductor device of any preceding claim, wherein the second part comprises:
a first oxide semiconductor pattern; and
a second oxide semiconductor pattern on the first oxide semiconductor pattern,
wherein a thickness (W4) of the first oxide semiconductor pattern in the first direction is greater than a thickness (W2) of the second oxide semiconductor pattern in the first direction.

11. The semiconductor device of any preceding claim, wherein:
the mold structure (MS) comprises a first mold pattern (131), a second mold pattern (132), and a third mold pattern (133) that are sequentially stacked on the bit line (BL),
the second mold pattern (132) comprises a material different from a material of the first mold pattern (131) and a material of the third mold pattern (133), and
a thickness (132H) of the second mold pattern (132) is greater than a thickness (131H) of the first mold pattern (131).

12. The semiconductor device of claim 11, wherein the second mold pattern (132) overlaps a central portion of the gate electrode (GE) in the first direction.

13. The semiconductor device of claim 11 or claim 12, wherein the first mold pattern (131) and the third mold pattern (133) comprise a same dielectric material.

14. The semiconductor device of any of claims 11-13, wherein the second mold pattern (132) comprises metal.

15. The semiconductor device of any of claims 11-13, wherein
the first mold pattern (131) and the third mold pattern (133) comprise one of silicon oxide and silicon nitride, and
the second mold pattern (132) comprises the other of the silicon oxide and the silicon nitride.
